(19) **Europäisches Patentamt / European Patent Office / Office européen des brevets**

(11) **EP 1 642 485 B1**

(12) **FASCICULE DE BREVET EUROPEEN**

(45) Date de publication et mention
de la délivrance du brevet:
**20.06.2007 Bulletin 2007/25**

(21) Numéro de dépôt: **04767874.3**

(22) Date de dépôt: **06.07.2004**

(51) Int Cl.:
*H05K 9/00* (2006.01)    *H01L 23/522* (2006.01)
*H01F 27/36* (2006.01)

(86) Numéro de dépôt international:
**PCT/FR2004/050313**

(87) Numéro de publication internationale:
**WO 2005/006828 (20.01.2005 Gazette 2005/03)**

(54) **DISPOSITIF ELECTRONIQUE MUNI D'UN BLINDAGE MAGNETIQUE**

MIT MAGNETABSCHIRMUNG AUSGESTATTETE ELEKTRONISCHE EINRICHTUNG

ELECTRONIC DEVICE PROVIDED WITH A MAGNETIC SCREENING

(84) Etats contractants désignés:
**AT BE BG CH CY CZ DE DK EE ES FI FR GB GR HU IE IT LI LU MC NL PL PT RO SE SI SK TR**

(30) Priorité: **08.07.2003 FR 0350305**

(43) Date de publication de la demande:
**05.04.2006 Bulletin 2006/14**

(73) Titulaire: **COMMISSARIAT A L'ENERGIE ATOMIQUE**
**75015 Paris (FR)**

(72) Inventeurs:
• **ADENOT-ENGELVIN, Anne Lise**
  **F-37000 Tours (FR)**
• **REYNET, Olivier**
  **F-37170 Chambray les Tours (FR)**
• **ACHER, Olivier**
  **F-37260 Monts (FR)**

(74) Mandataire: **Poulin, Gérard et al**
**Brevatome**
**3, rue du Docteur Lancereaux**
**75008 Paris (FR)**

(56) Documents cités:
**FR-A- 2 665 809**

• **KONDO K ET AL: "CONDUCTED NOISE SUPPRESSION EFFECT UP TO 3 GHZ BY NIZN FERRITE FILM PLATED AT 90 DEG C DIRECTLY ONTO PRINTED CIRCUIT BOARD" JOURNAL OF APPLIED PHYSICS, AMERICAN INSTITUTE OF PHYSICS. NEW YORK, US, vol. 93, no. 10, PART 3, 15 mai 2003 (2003-05-15), pages 7130-7132, XP001165965 ISSN: 0021-8979**
• **PATENT ABSTRACTS OF JAPAN vol. 1999, no. 12, 29 octobre 1999 (1999-10-29) & JP 11 186781 A (KOKUSAI KIBAN ZAIRYO KENKYUSHO:KK), 9 juillet 1999 (1999-07-09)**
• **DEPROT S ET AL: "Frequency response engineering of CoFeNiBSi microwires in the gigahertz range" JOURNAL OF MAGNETISM AND MAGNETIC MATERIALS, ELSEVIER, AMSTERDAM, NL, vol. 242-245, avril 2002 (2002-04), pages 247-250, XP004358668 ISSN: 0304-8853 cité dans la demande**
• **SHIRAKAWA K ET AL: "THIN FILM CLOTH-STRUCTURED INDUCTOR FOR MAGNETIC INTEGRATED CIRCUIT" IEEE TRANSACTIONS ON MAGNETICS, IEEE INC. NEW YORK, US, vol. 26, no. 5, 1 septembre 1990 (1990-09-01), pages 2262-2264, XP000150520 ISSN: 0018-9464**

EP 1 642 485 B1

## Description

### DOMAINE TECHNIQUE

La présente invention concerne un dispositif électronique muni d'un blindage magnétique présentant un pic de pertes magnétiques résonant.

### ETAT DE LA TECHNIQUE ANTERIEURE

Les dispositifs électroniques de l'art connu peuvent voir leurs performances améliorées de façon non négligeable par suppression de parasites qui perturbent leur fonctionnement.

Une première solution pour obtenir un tel résultat consiste à blinder les câbles qui transmettent ces parasites, les connexions qui les laissent entrer dans lesdits dispositifs électroniques, et les circuits qui les génèrent, en utilisant le principe de la cage de Faraday, c'est-à-dire en utilisant une gaine ou un boîtier qui réfléchit les perturbations incidentes vers l'extérieur. Mais dans cette solution, les signaux perturbateurs émis à l'intérieur du blindage lui sont alors renvoyés.

Une seconde solution consiste à atténuer les parasites ou à les supprimer définitivement. On a alors recours à des matériaux présentant des pics de pertes magnétiques qui atténuent les émissions électromagnétiques.

Aux fréquences allant de 10 kHz à 3 GHz, les matériaux magnétiques doux (oxydes ferrimagnétiques, métaux ferromagnétiques) sont particulièrement efficaces. Mais une élaboration de tels matériaux sous une forme souple pour permettre une conformation facile, en constituant une gaine ou un boîtier, exclut l'utilisation des techniques de mise en oeuvre habituelles de ces matériaux: frittage des oxydes ferromagnétiques, forgeage des métaux ferromagnétiques. Les matériaux ferromagnétiques utilisés alors sont souvent constitués d'un élastomère chargé avec des particules magnétiques, de feuillards minces, de fils ou de textiles et tricots métalliques.

Pour atteindre des fréquences élevées (typiquement 1-1000 MHz), il est nécessaire de diviser les dimensions géométriques caractéristiques (épaisseur, rayon,...) de ces matériaux afin de ne pas être gênés par leur caractère métallique (effet de peau). La grande résistivité relative des métaux ferromagnétiques à l'état amorphe ou nano-cristallisé est particulièrement favorable pour de telles fréquences.

L'utilisation sous forme de poudre fine de ces matériaux n'est pas favorable en raison du caractère généralement plus haute fréquence de ces poudres dû à leur anisotropie de forme. Une grande variété de matériaux ferromagnétiques doux du commerce ayant une dimension très réduite (fils, rubans, couches minces, plaquettes, poudres...) est particulièrement adaptée pour de telles applications.

Des exemples d'une utilisation de matériaux ferromagnétiques doux ayant une dimension très réduite sont donnés dans les documents référencés [1] et [2] en fin de description, dans lequel on utilise des particules ferromagnétiques incorporées dans un élastomère. Comme décrit dans le document référencé [3] des filaments ferromagnétiques gainés de verre ont une perméabilité parallèle au filament lorsque le signe du coefficient de couplage magnéto-élastique (magnétostriction) est négatif. Ils sont alors particulièrement attractifs dans la mesure où :

- le diamètre métallique est faible devant la longueur d'onde,
- leur gaine de verre leur confère une isolation électrique,
- leur élaboration par le procédé de l'art connu dénommé de « Taylor Ulitovsky » est facile,
- leurs caractéristiques mécaniques permettent un traitement par des technologies dérivées de la voie textile ou du câblage électrique (guipage, tissage, tricotage, ...).

Ils peuvent donc être utilisés dans des câbles-filtres par exemple passe-bas, comme décrit dans les documents référencés [4] et [5]. Mais dans ces documents, la position en fréquence du pic de pertes magnétiques est un paramètre lourd et coûteux à contrôler dans la mesure où un tel contrôle peut nécessiter un changement d'alliage, une modification d'un paramètre du procédé de fabrication, ou des traitements post-élaboration, comme décrit dans le document référencé [6].

De manière générale, l'efficacité des matériaux de blindage et de filtrage à une fréquence donnée est essentiellement conditionnée par leurs pertes magnétiques, c'est-à-dire par leur perméabilité imaginaire. Les matériaux magnétiques, en effet, ont généralement une perméabilité imaginaire qui présente un pic dont la fréquence de résonance et la largeur de bande sont liées à leurs caractéristiques. Un ajustement de la fréquence de résonance en jouant sur la nature et les caractéristiques du matériau est alors possible. Par contre, la largeur de la raie d'absorption est toujours supérieure à 500 MHz dans les matériaux ferromagnétiques, ce qui est gênant lorsque l'on veut filtrer une bande de fréquence plus étroite que 500 MHz et laisser passer le reste du signal.

Le document JP 11 186 781 A décrit un dispositif selon le préambule de la revendication 1.

L'invention a pour objet de proposer une solution à ce problème en permettant un ajustement de la largeur du pic de pertes magnétique , typiquement jusqu'à des valeurs de l'ordre de 1 MHz, un réglage aisé de la fréquence de résonance, et une augmentation significative du niveau du maximum des pertes magnétiques, dans le cas où l'on recherche des largeurs de bande faibles par rapport aux matériaux conventionnels, le filtrage étant alors plus efficace, ou bien, à efficacité donnée, moins de matériau de filtrage étant nécessaire.

## EXPOSÉ DE L'INVENTION

L'invention a pour objet de proposer un dispositif selon la revendication 1. Les modes préférentiels de réalisation sont définis dans les revendications 2-17.

L'invention concerne un dispositif électronique muni d'un blindage magnétique présentant un pic de pertes magnétiques résonant, caractérisé en ce que ce blindage comprend au moins un bobinage inductif constitué d'au moins un segment de fil métallique bobiné autour d'au moins un ensemble de filaments magnétiques.

Les filaments magnétiques peuvent être gainés de verre. Le diamètre du fil métallique constituant le bobinage inductif peut être compris entre 5 $\mu$m et 1 mm. La longueur de ce fil peut être comprise entre 0,001 mm et 20 cm. La surface d'une spire peut être comprise entre 0,01 mm$^2$ et 1 cm$^2$. Le nombre de spires peut être compris entre 0,5 et 50. Chaque segment peut comprendre plusieurs bobinages de fil métallique superposés. Ces bobinages peuvent être réalisés en sens inverse. La longueur sur laquelle s'étend un segment peut être comprise entre 0 et 50 mm. La distance entre deux segments inductifs voisins peut être comprise entre 0 et 50 mm. On peut combiner au moins deux segments inductifs de caractéristiques différentes. On peut utiliser au moins un fil textile sans propriétés magnétiques ou électriques pour assurer le maintien des filaments. On peut utiliser un fil non conducteur qui porte les segments conducteurs. On peut utiliser un fil conducteur conformé, la fixation de l'ensemble fil conducteur + filaments magnétiques étant réalisée en le coulant dans une résine, le fil conducteur étant sectionné aux endroits désirés afin de réaliser les segments inductifs. L'ensemble fil conducteur + filaments magnétiques peut être sectionné avec des rainures d'une profondeur égale au diamètre du fil et par exemple sur une longueur comprise entre 0,1 à 50 mm.

Dans un premier mode de réalisation le fil ainsi réalisé est bobiné sur l'âme d'un câble.

Dans un second mode de réalisation au moins une couche de blindage est disposée sur un boîtier qui génère au moins une perturbation selon une polarisation. Le fil de blindage est disposé dans chaque couche de façon à atténuer les perturbations en le plaçant parallèlement au champ magnétique d'une perturbation. Les segments inductifs peuvent être espacés périodiquement, leur répartition dans chaque couche de blindage étant elle aussi périodique. On peut utiliser un bi-couche de blindage, une première couche traitant une première polarisation et étant transparente dans l'autre, une deuxième couche traitant une deuxième polarisation, le fil de blindage de cette deuxième couche étant sectionné régulièrement de manière à couper l'effet réflecteur lié à la conductivité des filaments magnétiques.

## BRÈVE DESCRIPTION DES DESSINS

La figure 1 illustre le dispositif de l'invention.

La figure 2 illustre une installation de guipage.

La figure 3 illustre un premier mode de réalisation du dispositif de l'invention, sous la forme d'un câble blindé.

Les figures 4, 5A et 5B illustrent un second mode de réalisation du dispositif de l'invention.

Les figures 6 et 7 illustrent les courbes de la perméabilité imaginaire en fonction de la fréquence pour deux exemples du dispositif de l'invention différents.

## EXPOSÉ DÉTAILLÉ DE MODES DE RÉALISATION PARTICULIERS

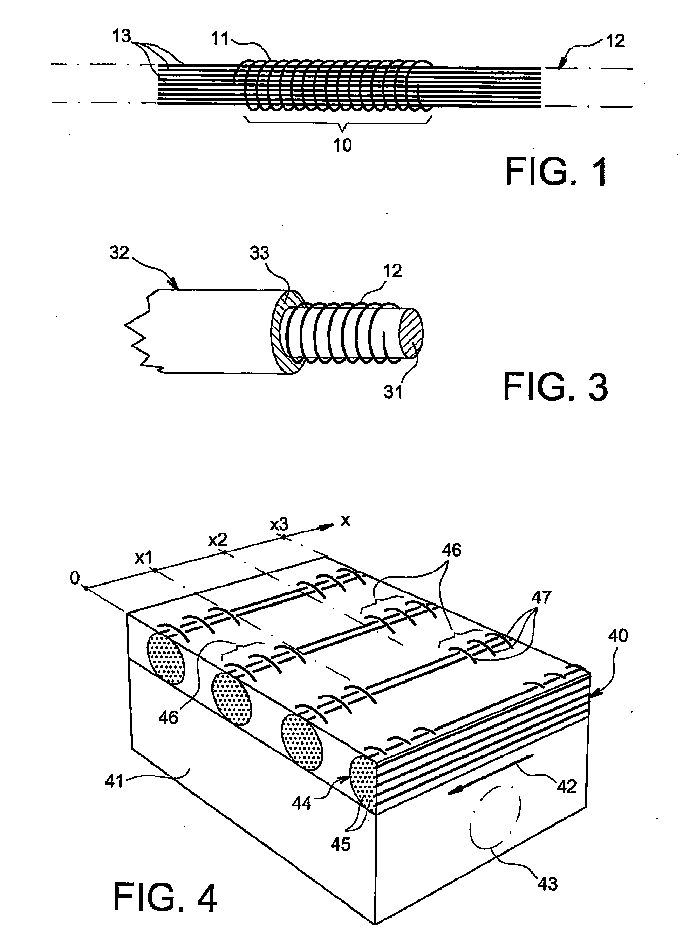

Dans le dispositif de l'invention, tel qu'illustré sur la figure 1, au moins un segment 10 de fil métallique 11 constituant un blindage est bobiné, par exemple par la technique de guipage, sur un fil 12, constitué d'un ensemble de filaments magnétiques 13. Plusieurs segments de ce type peuvent ainsi être bobinés, par exemple régulièrement, sur le fil 12.

Les filaments magnétiques 13 peuvent être des filaments ferromagnétiques gainés de verre en raison des avantages qui ont été cités précédemment. De tels filaments ferromagnétiques, dont l'alliage est choisi de façon à avoir une perméabilité parallèle au fil 12 élevée, constituent le matériau magnétique de base. Les règles de conception de tels filaments sont données dans les documents référencés [7] et [8].

Les segments 10 jouent le rôle de bobinages inductifs résonants. Leurs caractéristiques électriques et géométriques, conductivité, diamètre, longueur, et pas de bobinage, règlent la position en fréquence et la largeur du pic de pertes magnétiques.

La conductivité du fil 11 joue, par exemple, sur la résistance de l'élément inductif : plus la conductivité de ce fil est importante, plus la largeur du pic est étroit. La résistivité (inverse de la conductivité) varie fortement en fonction de la nature de l'alliage utilisé. On trouve couramment des fils ayant une résistance linéique de :

- 535, 5 Ohm/m (par exemple Isa-Chrom 80, d'un diamètre 50 $\mu$m, de la société IsabellenHuette Heusler GMBH),
- 169 Ohm/m (par exemple Resistherm, d'un diamètre 50 $\mu$m, de la société IsabellenHuette Heusler GMBH),
- 40 Ohm/m (par exemple Nickel pur à 99.6%, d'un diamètre 50 $\mu$m, de la société IsabellenHuette Heusler GMBH),
- 3,57 Ohm/m (par exemple Cuivre E-Kupfer d'un diamètre 80 $\mu$m, de la société IsabellenHuette Heusler GMBH).

Le diamètre du fil 11 et l'aire des spires qu'il constitue (nombre de spires x surface) jouent sur l'inductance du bobinage : plus le fil est fin et l'aire des spires étendue, plus la fréquence de résonance du bobinage diminue.

Le diamètre du fil 11 peut être compris entre 5 μm et 1 mm. La longueur du fil 11 bobiné dans chaque segment 10 peut être comprise entre de 0,001 mm et 20 cm. La surface d'une spire peut être comprise entre 0,01 mm$^2$ et 1 cm$^2$. Le nombre de spires de chaque segment 10 peut être comprise entre 0,5 et 50. Plusieurs bobinages superposés, éventuellement réalisés en sens inverse, peuvent constituer chaque segment 10. La longueur sur laquelle s'étend le bobinage de chaque segment 10 peut être comprise entre 0 et 50 mm. La distance entre deux segments inductifs voisins 10 peut être comprise entre 0 (segments quasi-jointifs) et 50 mm. Les différents segments inductifs 10 peuvent avoir des caractéristiques différentes de façon à créer un spectre de pertes magnétiques avec deux ou plusieurs pics de perméabilité imaginaire.

La technique utilisée pour constituer les enroulements des segments conducteurs 10 autour de l'ensemble de filaments magnétiques 13 est apparentée à la technique de guipage, qui est une technique de finition très utilisée pour les fils textiles. Les paramètres du guipage, nombre de fils de guipage, sens de guipage (en S ou en Z), et pas de guipage sur le fil, sont des variables qui permettent de réaliser des segments inductifs 10 aux propriétés différentes. Le guipage avec, par exemple, deux fils tournant en sens contraire permet d'augmenter l'effet inductif du bobinage sans étendre sa longueur et modifie les couplages du bobinage inductif avec le champ électrique parallèle au bobinage. La fonction de maintien des filaments 13 peut être assurée par un ou plusieurs fils textiles sans propriétés magnétiques ou électriques. On peut alors ajouter une torsion importante des filaments 13 de façon à augmenter la résistance mécanique du fil 12 (si un filament est coupé, il ne diminue pas la résistance globale du fil car il est « coincé » par la torsion).

Sur l'installation de guipage, illustrée sur la figure 2, le fil 12 est obtenu par l'assemblage de plusieurs filaments magnétiques 13 provenant de bobines 20, après passage dans deux filières 21 et 22. Une bobine réceptrice 23 ayant un sens de rotation 24 combinée à un peigne trancanant non représenté, ayant un mouvement de déplacement transversal 28, permet de stocker un fil 29 constitué dudit fil 12 après passage sur une roue tournante 25, sur lequel est venu s'enrouler un fil 11 issu d'une bobine de guipage 26 en rotation 27.

La réalisation des segments conducteurs 10 peut se faire soit avant le guipage par exemple en constituant au préalable un fil non conducteur qui porte ces segments conducteurs 10. Ce peut être par exemple un fil textile sur lequel on a déposé une peinture conductrice, ce fil servant à guiper les filaments 13. Les segments 10 assurent alors le maintien des filaments 13.

On peut aussi réaliser le guipage des filaments 13 à l'aide du fil conducteur 11, conformer le fil 12 ainsi obtenu, assurer la fixation de l'ensemble par exemple en le coulant dans une résine, et sectionner le fil conducteur aux endroits désirés afin de réaliser les segments inductifs 10.

Pour sectionner l'ensemble fil conducteur 11 + filaments magnétiques 13 on peut réaliser des rainures de longueur comprise entre 0,1 et 50 mm avec des longueurs de filaments magnétiques comprises entre 0,1 et 50 mm.

Dans un premier mode de réalisation de l'invention, le fil 12, réalisé comme décrit précédemment, est conformé comme matériau de blindage ou de filtrage en le bobinant sur l'âme d'un câble 32, comme illustré sur la figure 3. Suivant la spécification d'atténuation de ce câble 32 selon les bandes de fréquences utilisées, on élabore un fil de blindage 12 dont les segments conducteurs 10 répondent à cette spécification. Le champ magnétique généré par un tel câble 32 étant orthoradial, la bonne géométrie d'utilisation du fil de blindage 12 consiste à tourner le fil de blindage autour de l'âme du câble 32 de façon à optimiser l'effet de l'absorption du champ par le fil. Ce fil 12 est ainsi bobiné autour de la structure interne 31 de ce câble 32, qui comporte également une couche externe 33.

Dans un second mode de réalisation, illustré sur la figure 4, une couche de blindage 40 selon l'invention est placée sur un boîtier 41 subissant une perturbation selon une direction 42 dans une zone 43, pour blinder celui-ci en permettant de filtrer cette perturbation. Les fils de blindage 44, constitué de filaments magnétiques 45, sont disposés parallèlement au champ magnétique de la perturbation de manière à atténuer celle-ci. Huit segments inductifs 46, de 3 spires 47 chacun, sont enroulés autour de ces fils de blindage 44. La densité de ces segments inductifs 46, tels que représentés, est faible afin de préserver la clarté de la représentation. Mais elle peut atteindre des valeurs plus importantes (par exemples des motifs jointifs) en pratique. A titre d'exemple, sur la figure 4, les segments inductifs 46 sont espacés périodiquement sur le fil de blindage 44, leur répartition dans la couche de blindage 40 est elle aussi périodique. Les segments 46 sont placés à des abscisses x (parallèle au fil) identiques.

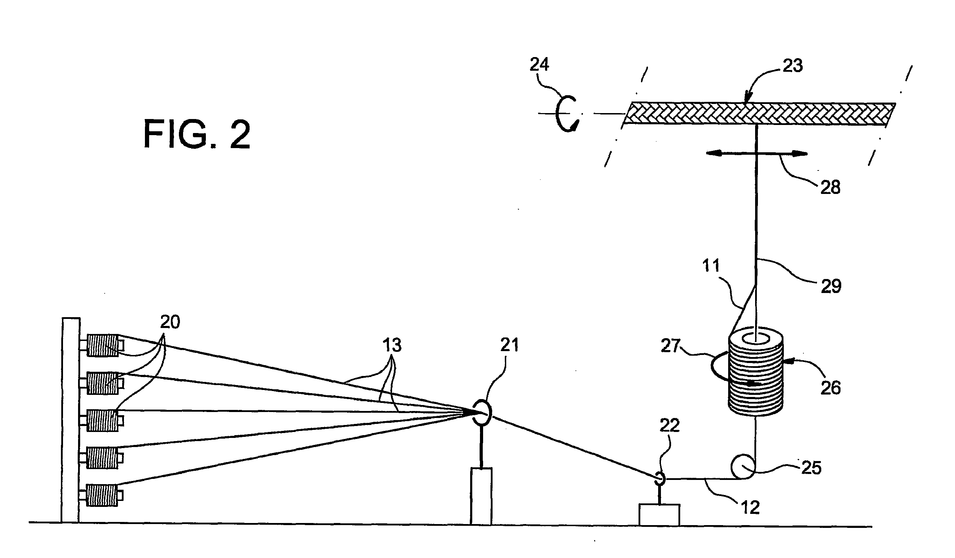

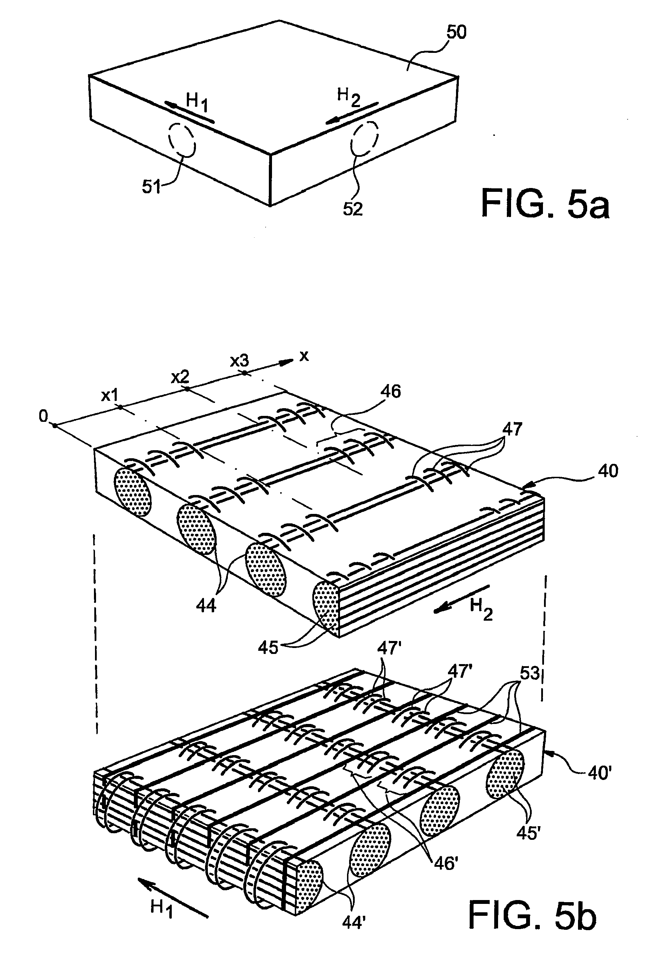

Pour augmenter l'efficacité du blindage, on peut superposer plusieurs couches de blindage. Ainsi, comme illustré sur la figure 5, on peut utiliser un bi-couche de blindage illustré sur la figure 5B à placer sur un boîtier 50 illustré sur la figure 5A, dans lequel les perturbations générées comportent des composantes dans les deux polarisations en champ magnétique. Les zones 51 et 52 sont respectivement des zones perturbées suivant la polarisation H1 et suivant la polarisation H2. Chaque couche de blindage traite une polarisation et est transparente dans l'autre, et l'autre couche traite l'autre polarisation. Pour obtenir une couche inférieure 40' transparente, les fils de blindage 44' de cette couche sont sectionnés régulièrement, par exemple à l'aide de rainure 53, pour couper l'effet réflecteur lié à la conductivité des filaments magnétiques 45'. De telles coupures peuvent être réalisées en même temps que les coupures que l'on effectue sur le fil de guipage conducteur utilisé pour réaliser les segments inductifs 46'. De telles rainures 53 permettent d'assurer la transparence de la seconde couche 40' vis-à-vis du champ électrique associé à la polarisation H2.

Des bobinages réalisés autour de matériaux magnétiques ont déjà été proposés, par exemple dans le document référencé [9].

Le caractère conducteur le long de l'axe des filaments ferromagnétiques change le comportement hyperfréquence. Il en résulte une absence de résonance parasite sur la permittivité. Les possibilités d'ingénierie de la réponse en fréquence (largeur de bande, position du pic d'absorption) offertes par les segments conducteurs (pas de guipage, nombre de tours,...) permettent de réaliser l'absorption dans les deux polarisations sur une même bande de fréquence.

Exemples de réalisation

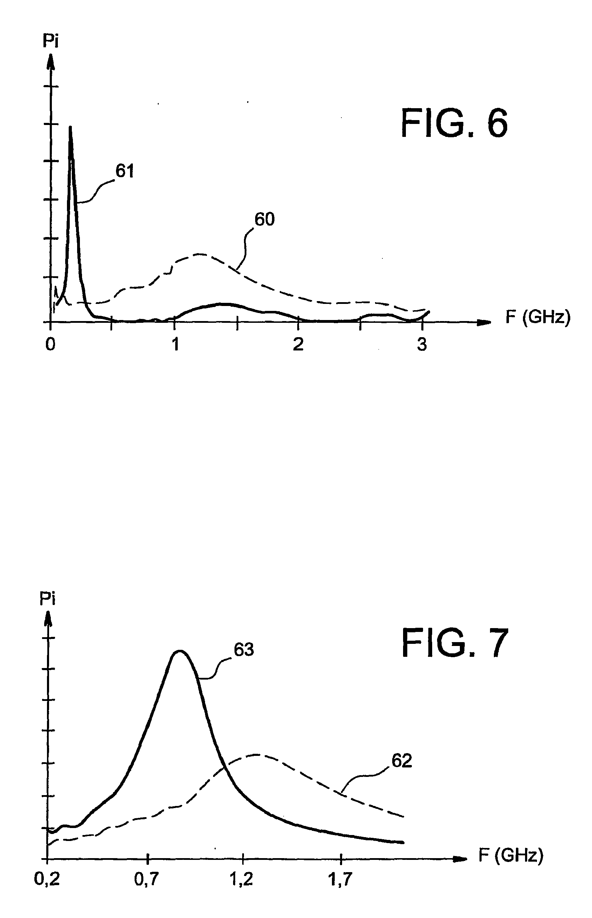

Dans un premier exemple de réalisation on utilise un ensemble de filaments ferromagnétiques gainés de verre élaborés selon le procédé Taylor Ulistovsky. Ces filaments sont réalisés en un alliage doux commercial CoFeNiMoSiB. Le coeur métallique de ces filaments ferromagnétiques a un diamètre de 4 micromètres et la gaine de verre une épaisseur de 2 micromètres. Comme illustré sur la figure 1, un fil de cuivre 11 est bobiné sur ces filaments 13 pour former un échantillon dont la perméabilité est mesurée par une méthode de caractérisation hyperfréquence. Le fil de cuivre est un fil de cuivre émaillé de 50 $\mu$m de diamètre, qui est sectionné périodiquement afin de réaliser des segments de fil conducteur, dont la période est de 6,2 mm, la longueur de la rainure alors réalisée étant de 0,6 mm. L'aire des spires est de 1 mm$^2$. La longueur de ces segments est de 80 mm. Le pas de guipage est de 0,4 mm. La figure 6 illustre une courbe 60 de perméabilité imaginaire Pi d'un tel échantillon sans segments conducteurs et une courbe 61 de perméabilité magnétique Pi d'un tel échantillon avec les segments conducteurs 61 selon l'invention. La position du pic de résonance de la perméabilité Pi est passée de 1,2 GHz à 0,2 GHz grâce aux segments inductifs, tandis que la largeur de bande $\Delta f$ à mi-hauteur est passée de 768 MHz à 68 MHz. Si on définit comme la sélectivité du filtre le rapport $\dfrac{f}{\Delta f}$, on a multiplié celle-ci par 2 puisqu'elle est passée de 1,5 à 3.

Dans un second exemple de réalisation, pour mettre en évidence la facilité avec laquelle le blindage selon l'invention peut être utilisé pour filtrer une bande de fréquence, on utilise un échantillon réalisé comme précédemment mais avec des longueurs de segments inductifs de 20 mm et un pas de guipage de 1,5 mm. La position du pic du maximum des pertes est passé de 1,2 GHz (courbe 62 sans segments inductifs) à 0,8 GHz (courbe 63 avec segments inductifs) grâce aux segments inductifs, tandis que la largeur de bande à mi-hauteur est passée de 768 MHz à 400 MHz. La sélectivité du filtre est passée de 1,5 à 2.

REFERENCES

[1] Documentation Tokin http://www.nec-tokin.com

[2] EP 1143458

[3] "High frequency losses of ferromagnetic wires near the gyromagnetic resonance" de S. Deprot, A.-L. Adenot, F. Bertin, E. Hervé et O. Acher (IEEE Trans. Magn. 37, 2404, 2001).

[4] WO 00/68959

[5] WO 00/31753

[6] "Frequency response engineering of CoFeNiBSi microwires in the GHz range" de S. Deprot, A. L. Adenot, F. Bertin, et O. Acher (J. Magn. Mater 242, 247, 2002).

[7] "High frequency permeability of thin amorphous wires with various anisotropic fields" de M.J. Malliavin, O. Acher, C. Boscher, F. Bertin et V.S. Larin (J. Magn. Magn. Mater. 196-197, 420, 1999).

[8] "Parallel permeability of ferromagnetic wires up to GHz frequencies" de O. Acher, A.L. Adenot, et S. Deprot, (J. Magn. Magn. Mater 249, 264, 2002).

[9] "Resonance phenomena in chiral and chiro-ferrite one dimensional media in the microwave band" de G. A. Kraftmakher, Yu N. Kazantsev (J. Comm. Tech. Elec. 44, 1393-1402, 1999).

Revendications

1. Dispositif électronique muni d'un blindage magnétique présentant un pic de pertes magnétiques résonant, **caractérisé en ce que** ce blindage comprend au moins un bobinage inductif constitué d'au moins un segment (10, 46) de fil métallique bobiné autour d'au moins un ensemble (12, 44) de filaments magnétiques (13, 45).

2. Dispositif selon la revendication 1, dans lequel les filaments magnétiques (13, 45) sont gainés de verre.

**3.** Dispositif selon la revendication 1, dans lequel le diamètre du fil métallique est compris entre 5 $\mu$m et 1 mm, la longueur de ce fil est comprise entre 0,001 mm et 20 cm, la surface d'une spire est comprise entre 0,01 mm$^2$ et 1 cm$^2$, le nombre de spires est compris entre 0,5 et 50.

**4.** Dispositif selon la revendication 1, dans lequel chaque segment comprend plusieurs bobinages de fil métallique superposés.

**5.** Dispositif selon la revendication 4, dans lequel ces bobinages sont réalisés en sens inverses.

**6.** Dispositif selon la revendication 1, dans lequel chaque segment (10, 46) a une longueur comprise entre 0 et 50 mm, la distance entre deux segments voisins (10, 46) est comprise entre 0 et 50 mm.

**7.** Dispositif selon la revendication 1, dans lequel on combine au moins deux segments inductifs de caractéristiques différentes.

**8.** Dispositif selon la revendication 1 comprenant au moins un fil textile sans propriétés magnétiques ou électriques pour assurer le maintien des filaments (13, 45).

**9.** Dispositif selon la revendication 1 comprenant un fil non conducteur qui porte les segments conducteurs.

**10.** Dispositif selon la revendication 1, dans lequel le fil conducteur est conformé, la fixation de l'ensemble fil conducteur + filaments magnétiques étant réalisée en le coulant dans une résine et en sectionnant le fil conducteur aux endroits désirés afin de réaliser les segments inductifs.

**11.** Dispositif selon la revendication 10, dans lequel l'ensemble fil conducteur + filaments magnétiques est sectionné avec des rainures.

**12.** Dispositif selon la revendication 11, dans lequel des rainures ont une profondeur égale au diamètre du fil et sur une longueur comprise entre 0,1 et 50 mm.

**13.** Dispositif selon l'une quelconque des revendications précédentes, dans lequel le fil de blindage (12) est bobiné sur l'âme d'un câble (32).

**14.** Dispositif selon la revendication 1, dans lequel au moins une couche de blindage (40) est disposée sur un boîtier (41) qui génère au moins une perturbation selon une polarisation, dans lequel le fil de blindage est structuré dans chaque couche de façon à atténuer une perturbation en plaçant celui-ci parallèlement au champ magnétique de cette perturbation.

**15.** Dispositif selon la revendication 14, dans lequel les segments inductifs (46) sont espacés périodiquement sur le fil de blindage (44), leur répartition dans chaque couche de blindage (40) étant elle aussi périodique.

**16.** Dispositif selon la revendication 14 comprenant deux couches de blindage (40, 40').

**17.** Dispositif selon la revendication 16, dans lequel une première couche (40) traite une première polarisation et est transparente dans l'autre, une deuxième couche (40') traite une deuxième polarisation, le fil de blindage de cette deuxième couche étant sectionné régulièrement (53) de manière à couper l'effet réflecteur lié à la conductivité des filaments magnétiques.

**Claims**

**1.** Electronic device furnished with magnetic screening having a peak of resonant magnetic losses, **characterised in that** the screening comprises at least one inductive winding constituted by at least one segment (10, 46) of metallic wire wound around at least one assembly (12, 44) of magnetic filaments (13, 45).

**2.** Device according to claim 1, wherein the magnetic filaments (13, 45) are sheathed in glass.

**3.** Device according to claim 1, wherein the diameter of the metallic wire is comprised between 5 $\mu$m and 1 mm, the length of this wire is comprised between 0.001 mm and 20 cm, the surface of a turn is comprised between 0.01 mm$^2$ and 1 cm$^2$, and the number of turns is comprised between 0.5 and 50.

**4.** Device according to claim 1, wherein each segment comprises plural superposed windings of metallic wire.

**5.** Device according to claim 4, wherein these windings are performed in opposite directions.

**6.** Device according to claim 1, wherein each segment (10, 46) has a length comprised between 0 and 50 mm, the distance between two neighbouring segments (10, 46) being comprised between 0 and 50 mm.

**7.** Device according to claim 1, wherein at least two inductive segments of different characteristics are combined.

**8.** Device according to claim 1, comprising at least one textile thread without magnetic or electrical properties to ensure keeping the filaments in place (13, 45).

9. Device according to claim 1, comprising a nonconductive wire which carries the conductive segments.

10. Device according to claim 1, wherein conductive wire is conformed, the fixation of the assembly of conductive wire + magnetic filaments being effected by embedding in a resin and sectioning the conductive wire at desired places in order to produce the inductive segments.

11. Device according to claim 10, wherein the assembly of conductive wire + magnetic filaments is sectioned with grooves.

12. Device according to claim 11, wherein the grooves have a depth equal to the diameter of the wire and over a length between 0.1 and 50 mm.

13. Device according to any one of the foregoing claims, wherein the screening wire (12) is wound on a core of a cable (32).

14. Device according to claim 1, wherein at least one layer of screening (40) is disposed on a casing (41) which generates at least one interference according to a polarisation, in which the screening wire is structured in each layer so as to attenuate an interference by placing it parallel to the magnetic field of this interference.

15. Device according to claim 14, wherein the inductive segments (46) are spaced periodically on the screening wire (44), their distribution in each screening layer (40) itself also being periodic.

16. Device according to claim 14 comprising two screening layers (40, 40').

17. Device according to claim 16, wherein a first layer (40) deals with a first polarisation and is transparent in the other, and a second layer (40') deals with a second polarisation, the screening wire of this second layer being regularly sectioned (53) so as to cut off the reflector effect linked to the conductivity of the magnetic filaments.

**Patentansprüche**

1. Elektronische Vorrichtung, ausgerüstet mit einer magnetischen Abschirmung, deren magnetische Verluste einen Resonanzpeak aufweisen, **dadurch gekennzeichnet, dass** diese Abschirmung wenigstens eine induktive Spule umfasst, gebildet durch mindestens ein Metallfadensegment (10, 46), das um wenigstens eine Gruppe (12, 44) von magnetischen Fäden (13, 45) herum gespult ist.

2. Vorrichtung nach Anspruch 1, bei der die magnetischen Fäden (13, 45) mit Glas ummantelt sind.

3. Vorrichtung nach Anspruch 1, bei der der Durchmesser des Metallfadens zwischen 5 $\mu$m und 1 mm enthalten ist, wobei die Länge dieses Fadens zwischen 0,001 mm und 20 cm enthalten ist, die Fläche einer Windung zwischen 0,01 mm$^2$ und 1 cm$^2$ enthalten ist und die Windungszahl zwischen 0,5 und 50 enthalten ist.

4. Vorrichtung nach Anspruch 1, bei der jedes Segment mehrere übereinanderliegende Metallfadenwicklungen umfasst.

5. Vorrichtung nach Anspruch 4, bei der diese Wicklungen in umgekehrten Richtungen realisiert sind.

6. Vorrichtung nach Anspruch 1, bei der jedes Segment (10, 46) eine zwischen 0 und 50 mm enthaltene Länge hat, wobei der Abstand zwischen zwei benachbarten Segmenten (10, 46) zwischen 0 und 50 mm enthalten ist.

7. Vorrichtung nach Anspruch 1, bei der man wenigstens zwei induktive Segmente mit unterschiedlichen Charakteristika kombiniert.

8. Vorrichtung nach Anspruch 1, die wenigstens einen Textilfaden ohne magnetische oder elektrische Eigenschaften umfasst, um die Stabilität der Fäden (13, 45) zu gewährleisten.

9. Vorrichtung nach Anspruch 1, die einen nichtleitfähigen Faden umfasst, der die leitfähigen Segmente trägt.

10. Vorrichtung nach Anspruch 1, bei der der leitfähige Faden angepasst wird, wobei die Fixierung des Ganzen aus leitfähigem Faden + magnetischen Fäden realisiert wird, indem man es in ein Harz taucht und indem man den leitfähigen Faden an den gewünschten Stellen sektioniert, um die induktiven Segmente zu realisieren.

11. Vorrichtung nach Anspruch 10, bei der das Ganze aus leitfähigem Faden + magnetischen Fäden mit Rillen sektioniert ist.

12. Vorrichtung nach Anspruch 11, bei der die Rillen eine Tiefe gleich dem Durchmesser des Fadens haben und dies über eine zwischen 0,1 und 50 mm enthaltene Länge.

13. Vorrichtung nach einem der vorangehenden Ansprüche, bei der der Abschirmungsfaden (12) auf den Kern eines Kabels (32) gespult ist.

**14.** Vorrichtung nach Anspruch 1, bei der wenigstens eine Abschirmungsschicht (40) auf einem Gehäuse (41) angebracht ist, das wenigstens eine Störung gemäß einer Polarisierung erzeugt, bei der der Abschirmungsfaden in jeder Schicht so strukturiert ist, dass er eine Störung dämpft, indem man ihn parallel zu dem Magnetfeld dieser Störung anordnet.

**15.** Vorrichtung nach Anspruch 14, bei der die induktiven Segmente (46) auf dem Abschirmungsfaden (44) periodisch beabstandet sind, wobei auch ihre Verteilung in jeder Abschirmungsschicht (40) periodisch ist.

**16.** Vorrichtung nach Anspruch 14 mit zwei Abschirmungsschichten (40, 40').

**17.** Vorrichtung nach Anspruch 16, bei der eine erste Schicht (40) eine erste Polarisierung behandelt und bei der anderen durchlässig ist, und eine zweite Schicht (40') eine zweite Polarisierung behandelt, wobei der Abschirmungsfaden dieser zweiten Schicht gleichmäßig sektioniert ist (53), um den mit der Leitfähigkeit der magnetischen Fäden verbundenen Reflexionseffekt zu unterbrechen.

FIG. 1

FIG. 3

FIG. 4

FIG. 2

EP 1 642 485 B1

FIG. 5a

FIG. 5b

FIG. 6

FIG. 7

## RÉFÉRENCES CITÉES DANS LA DESCRIPTION

**Documents brevets cités dans la description**

- JP 11186781 A
- EP 1143458 A
- WO 0068959 A
- WO 0031753 A


**Littérature non-brevet citée dans la description**

- **S. DEPROT ; A.-L. ADENOT ; F. BERTIN ; E. HERVÉ ; O. ACHER.** High frequency losses of ferromagnetic wires near the gyromagnetic resonance. *IEEE Trans. Magn.,* 2001, vol. 37, 2404
- **S. DEPROT ; A. L. ADENOT ; F. BERTIN ; O. ACHER.** Frequency response engineering of CoFeNiBSi microwires in the GHz range. *J. Magn. Mater,* 2002, vol. 242, 247
- **M.J. MALLIAVIN ; O. ACHER ; C. BOSCHER ; F. BERTIN ; V.S. LARIN.** High frequency permeability of thin amorphous wires with various anisotropic fields. *J. Magn. Magn. Mater.,* 1999, vol. 196-197, 420
- **O. ACHER ; A.L. ADENOT ; S. DEPROT.** Parallel permeability of ferromagnetic wires up to GHz frequencies. *J. Magn. Magn. Mater,* 2002, vol. 249, 264
- **G. A. KRAFTMAKHER ; YU N. KAZANTSEV.** Resonance phenomena in chiral and chiro-ferrite one dimensional media in the microwave band. *J. Comm. Tech. Elec.,* 1999, vol. 44, 1393-1402